Europäisches Patentamt

European Patent Office

Office européen des brevets

(19)

(11) EP 0 525 455 B1

(12) **EUROPEAN PATENT SPECIFICATION**

(45) Date of publication and mention
of the grant of the patent:
**30.09.1998 Bulletin 1998/40**

(51) Int Cl.6: **H01L 21/322**, H01L 21/304

(21) Application number: **92111576.2**

(22) Date of filing: **08.07.1992**

(54) **Extrinsic gettering for a semiconductor substrate**

Extrinsisches Gettering für ein halbleitendes Substrat

Piégeage extrinsèque pour un substrat semi-conducteur

(84) Designated Contracting States:
**DE FR GB**

(30) Priority: **19.07.1991 JP 203328/91**
**08.04.1992 JP 116891/92**

(43) Date of publication of application:
**03.02.1993 Bulletin 1993/05**

(73) Proprietor: **SHIN-ETSU HANDOTAI COMPANY**
**LIMITED**
**Chiyoda-ku Tokyo (JP)**

(72) Inventors:
 • **Netsu, Shigeyoshi**
  **68000 Ampang Selangor Darul Ehsan (MY)**
 • **Tomizawa, Shinichi**
  **Annaka-shi, Gunma-ken (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 251 280**

 • **JOURNAL OF THE ELECTROCHEMICAL**
  **SOCIETY vol. 129, no. 11, November 1982,**
  **MANCHESTER, NEW HAMPSHIRE US pages**
  **2527 - 2530 K.D.BEYER ET AL. 'Impurity**
  **gettering of silicon damage generated by ion**
  **implantation through SiO2 layers'**
 • **SOLID STATE ELECTRONICS vol. 30, no. 2,**
  **February 1987, OXFORD GB pages 209 - 211**
  **S.S.GONG ET AL. 'Implantation gettering in**
  **silicon'**
 • **IBM TECHNICAL DISCLOSURE BULLETIN. vol.**
  **20, no. 9, February 1978, NEW YORK US pages**
  **3454 - 3455 M.R.POPONIAK ET AL. 'Impurity**
  **gettering and removing gettered impurities'**
 • **PATENT ABSTRACTS OF JAPAN vol. 11, no. 88**
  **(E-490)(2535) 18 March 1987 & JP-A-61 240 638**
  **( FUJITSU ) 25 October 1986**

## Description

The present invention relates generally to a method of making a semiconductor substrate, and more particularly to such a method of making a semiconductor substrate which is composed of a silicon single crystal wafer having a small number of mechanical fractures on its back side and is able to maintain a lasting extrinsic gettering (EG) effect while it is prepared into semiconductor devices (hereinafter referred to for brevity as "devices").

In the process of preparation of devices, a silicon single crystal wafer (hereinafter referred to for brevity as "wafer") is subjected to various thermal processes during which time various kinds of crystal defects are induced due to oxygen, carbon, heavy metal impurities, etc. These defects may be produced on or in the vicinity of a surface of the wafer in which instance they will increase a leak current of the devices and eventually bring about a deterioration of the device performance characteristics and a reduction of the device manufacturing yield.

However, the microdefects and distortions observed either in the wafer or on the back side of the wafer opposing a mirror surface of the wafer have a function to collect and fix those impurities having an negative effect on the device characteristics and to remove a point defect related to generation of a defective device. This function is generally called "gettering" and, among others, such a gettering method which uses the mechanical fracture induced strain near the back side of the wafer is called "extrinsic gettering" (hereinafter referred to for brevity as "EG") while the gettering method which uses the microdefects distributed in the wafer is called "intrinsic gettering" (hereinafter referred to for brevity as "IG").

An EG method wherein a distorted layer is introduced into the back side of a silicon wafer by ion implantation so as to form gettering sides, is disclosed in the Article "Impurity Gettering of Silicon Damage Generated by Ion Implantation Through $SiO_2$ Layers", 1046 Journal of the Electrochemical Society, vol. 129 (1982), November, no. 11, Manchester, New Hampshire, USA.

Another known process of proving the EG is called a sandblasting method in which a fine particle is blasted against the back side of a wafer to form a distorted layer which will generate dislocations or stacking faults in a subsequent thermal process adapted in the preparation of devices, which dislocations or stacking faults are used as a gettering source. (Japanese Patent Laid-open Publication Nos. 53-128272 and 54-148474)

The known sandblasting method has a drawback, however, that the distorted layer formed in the back side of the wafer is likely to disappear when it is subjected to a thermal treatment at a high temperature in the process of preparation of the device. This drawback may be overcome by increasing the sandblasting damage to such an extent that a deep distorted layer is formed by the sandblasting. However, such an increased blasting damage will bring about formation of increased mechanical fractures which will produce dust and slip dislocations during the device preparation process and thus deteriorate the device performance characteristics and the device manufacturing yield.

With the foregoing drawbacks of the prior art in view, it is an object of this invention to provide a method of making a semi-conductor substrate having a distorted layer which is formed in the back side of a wafer by means of a dry or a wet sandblasting with generation of a small amount of mechanical fractures and which is capable of maintaining an EG effect long even when subjected to a high temperature thermal process in the course of preparation of devices.

According to one aspect of this invention, there is provided a method of making a semiconductor substrate, comprising the steps of: forming an inorganic protective film on a back side of a silicon single crystal wafer; and subsequently, introducing a distorted layer in the back side of the wafer by a sandblasting method.

A method of making the semiconductor substrate of this invention comprises the steps of: forming an inorganic protective film on a back side of a silicon single crystal wafer; and subsequently, introducing a distorted layer in the back side of the wafer by a sandblasting method.

The protective film includes a silicon oxide film and a silicon nitride film which are formed by thermal oxidation and thermal nitriding, respectively, of the wafer, a film of silicon, a silicon oxide or a silicon nitride which is formed by chemical vapor deposition, and an oxide film having a constituent metal other than silicon.

Particularly, when the silicon oxide film is used as the protective film, it is preferable that prior to the sandblasting process, the wafer is annealed. In this annealing process, an atmosphere of inert gas is replaced with an oxidizing atmosphere containing oxygen, so that a silicon oxide film thus produced can readily be used as the protective film.

In addition, if the protective film becomes unnecessary after the sandblasting process, it may be removed by a mechanical polishing or, in the case of the silicon oxide protective film, by using a conventional etching solution containing hydrofluoric acid as the main ingredient.

According to the method of this invention, the sandblasting operation is effected on the back side of the wafer via a protective film so that it is possible to effectively prevent the occurrence of mechanical fractures which is unavoidable in the case of the conventional sandblasting in which a fine particle (sand) is directly blown against the back side of the wafer.

In the case of a dry sandblasting, when a finely crushed particle of hard material is used, an edge of the fine particle impinges on the wafer surface at a high speed so that the kinetic energy of the fine particle acts, as a breaking force, on the wafer surface and sometimes produces local fractures or microcracks on the wafer surface. To cope with this problem, a wet sandblasting method has been proposed but a satisfactory result has not been obtained as yet.

The protective film provided formed by the method according to the present invention has a thickness which is appropriate to absorb the breaking force applied thereto during the sandblasting process so that the breaking force has no effect on the wafer. To this end, the protective film needs to have a certain degree of hardness, a certain degree of adhesion to the wafer, a certain degree of durability against fracture, and a thickness adjusted to meet the quality of the film. When these requirements are considered as a whole, a thermally oxidized silicon film or a silicon oxide film formed by chemical vapor deposition (CVD) is preferred.

The protective film may be formed by a wet method or process which preferably includes a wet oxidation process, an anodic oxidation process, and a liquid-phase film-forming process.

The wet oxidation process is performed by immersing the wafer in a liquid oxidizing agent such as hydrogen peroxide, nitric acid or sulfuric acid, an aqueous solution of a solid oxidizing agent such as permanganic acid, chromic acid, or perchloric acid, or a mixed aqueous solution of acids.

In order to protect the high purity wafer against contamination with impurities contained in chemicals, and as a high purity inexpensive chemical, a solution which is prepared by adding hydrogen peroxide to an oxidizing acid not dissolving $SiO_2$ is preferred.

That is, in a mixed aqueous solution such as $H_2SO_4 + H_2O_2$, $HCl + H_2O_2$, or $HNO_3 + H_2O_2$, a wafer is immersed at a temperature between the room temperature and several tens Celsius degrees for several minutes to several hours. As a result of this immersion, a thin film of $SiO_2$ is formed on a surface of the wafer.

The solution used in this instance is composed of 1 part by volume of $H_2O_2$ (30% hydrogen peroxide water) and 1-10 parts by volume of a concentrated acid. Within the range of concentration thus specified, the solution may be diluted with water at need.

In the anodic oxidation process, a mirror surface side of a wafer is attached to an anode, while the back side of the wafer is held in confrontation with a platinum cathode. While keeping this condition, a direct current is passed through an electrolyte containing an acid, a water-soluble organic substance or a water-soluble inorganic salt. Thus, the back side of the wafer is anodized. According to this process, only one selected side of the wafer can be covered with a protective film. The acid eligible for this purpose includes a normal acid such as hydrochloric acid, hydrofluoric acid or nitric acid. Similarly, the organic substance may be ethyl alcohol, ethylene glycol, or methyl acetamide. The inorganic salts may be $NaNO_3$, $KNO_3$, or $NH_4NO_3$.

The liquid-phase film-forming process is a film-forming method using a liquid-phase chemical reaction. For example, a wafer is immersed in a supersaturated aqueous solution of silicofluoric acid and then a metal Al is placed into the solution to start reaction. Thus the reaction proceeds according to the following reaction formulae (I) and (II) and eventually forms an $SiO_2$ film on a surface of the wafer.

$$H_2SiF_6 + 2H_2O \rightleftharpoons SiO_2 + 6HF \qquad \ldots\ldots(I)$$

$$6HF + Al \rightarrow H_3AlF_8 + 3/2H_2 \qquad (II)$$

According to the liquid-phase film-forming process, it is possible to form a protective film selectively on one or both sides of the wafer depending on a setting of the wafer in the solution. A film other than the oxide film can be formed through a different reaction which is achieved by an appropriate combination of different chemicals.

In addition to the advantages described above, the following additional advantageous effects are attainable by the present invention.

(a) It is possible to obtain a semiconductor substrate which exhibits a lasting EG effect when the semiconductor substrate is processed into a device.

As described above, the conventional sandblasting method is likely to damage the back side of the wafer, and it is effected to such an extent as to avoid damaging the wafer back side, a resulting distorted layer being quite unsatisfactory. According to the present invention, the back side of the wafer is covered with a protective film so that a strong mechanical energy can be applied to the back side of the wafer during the sandblasting process. The sandblasting process with a higher mechanical energy exhibits an EG effect of a higher level than that of the conventional sandblasting method. Such a high level EG effect never decreases even when the protective film is removed after the sandblasting process.

After the sandblasting, the wafer with the protective film left unremoved is put forward to a process of preparation of a device. In this instance, despite the presence of various heat treatments (or thermal processes), the distorted layer formed in the vicinity of the interface between the protective film and the wafer is in an unrecoverable condition. It can, therefore, be estimated that the duration of the EG effect is extended with an increase in bonding strength between the protective film and the wafer.

(b) When the protective film is formed of a silicon oxide film, a conventional semiconductor-wafer annealing process can be used with a slight modification that an inert gas atmosphere is replaced with an oxidizing atmosphere such as an atmosphere containing oxygen. Thus, the silicon oxide protective film is formed by the same process as done in the conventional method, and no additional process is necessary.

(c) When a process other than the thermal oxidation or the thermal nitriding is used for forming the protective film, that is, when CVD, for example, is employed, a separate process of forming the protective-film must be added, but any other process is not needed at all.

(d) The protective film is removed at need. In this instance, a protective-film removing process is necessary, but this process will not cause a remarkable change in the overall process for preparing the semiconductor substrate.

(e) The protective film need not be removed and when it is left unremoved, the following advantageous effects will be attained.

(e-i) When the semiconductor substrate is mirror-polished by the non wax polishing method, the protective film facilitates the direct setting of the semiconductor substrate to a support surface of a polishing machine.

(e-ii) The protective film protects the surface of the semiconductor substrate against contamination which may be caused by a cassette or the like when the semiconductor substrate is in a position between two succeeding processes or during the storage.

(e-iii) Generation of particles caused by the semiconductor substrate can be prevented.

The invention will be further described by way of the following examples which should be construed as illustrative rather than restrictive.

Examples 1 and 2 and Comparative Example 1

(a) Wafer Used in Experiment

15 samples of silicon single crystal wafers were prepared by slicing, chamfering, lapping and etching a p-type, <100>-oriented, 10-20Ω•cm resistivity, 125 mm diameter rod of Czochralski (CZ) grown silicon single crystal.

(b) Processes Effected on Wafer

The wafers thus obtained were treated under the same condition except for an atmosphere used in an annealing. The annealing used here was a conventional annealing process employed for a purpose of annihilation of oxygen donor. 5 wafers were used in a conventional method (Comparative Example 1), while the rest or 10 wafers were used in a method of this invention (Examples 1 and 2). Five out of ten wafers were subjected to etching to remove an oxide film after the sandblasting is achieved (Example 2).

(b-i) Processes Effected on Comparative Example 1 (Conventional Method):

wafer → annealing (650°C, 30 min., nitrogen gas atmosphere) → wet sandblasting (sand blasting pressure: 0.9 kg/cm$^2$) → inspection

(b-ii) Processes Effected on Examples 1 and 2 (Inventive Method):

wafer → annealing (650°C, 30 min., oxygen gas atmosphere) → wet sandblasting (sand blasting pressure: 0.9 kg/cm$^2$) → inspection

Regarding Examples 1 and 2, subsequent to the annealing process, the thickness of an oxide film formed on a surface of each wafer was measured by an ellipsometer. The results of this measurement indicated that the oxide films have thicknesses in the range of 35 - 80Å.

A quartz fine power of about 5µ in average diameter was used in the sandblasting process which was achieved under the same condition except for the blasting pressure.

(c) Method of Inspection

After the sandblasting process, each wafer was inspected for the following items.

(c-i) <u>Measurement on OSF (oxidation-induced stacking fault) on Back Side of Wafer</u>

Each wafer was thermally oxidized at 1100°C for 60 min. in an oxygen atmosphere, then an oxide film was etched off in a Secco etching solution, and the back side of the wafer was observed by an optical microscope for visual counting of OSF developed on the back side of the wafer.

(c-ii) <u>Number of Mechanical Fractures</u>

Using a 1500-power, scanning type electron microscope, the wafer surface was scanned cross-wise over 100 mm length in each scanning direction and the number of fractures observed during scanning was counted.

(c-iii) <u>Depth of Mechanical Fractures</u>

Fractures were measured for its depth by the angle polish method.

(d) <u>Test Results</u>

The results obtained are as shown in Table 1.

As is apparent from Table 1, in respect of the OSF density, no substantial difference is found between the conventional method (Comparative Example 1) and the inventive method (Examples 1 and 2). However, the number and depth of the mechanical fractures are remarkably reduced in the case of the inventive method (Examples 1 and 2).

A comparison between Example 1 and Example 2 indicates that the presence/absence of the oxide film does not cause any considerable change in the OSF density and, hence, the OSF density is not affected very much by the presence of the oxide layer.

In the conventional method (Comparative Example 1), if a wafer with an OSF density in excess of 1,000,000 pieces/$cm^2$ is desired, the resulting wafer will has a large number of mechanical fractures. These mechanical fractures can constitute a dust producing source when the wafer is used in the preparation of a device. Accordingly, this wafer is rejected as a defective wafer in comparison with the product inspection standards provided for semiconductor substrates.

Such a large number of mechanical fractures can be reduced when the sand blasting pressure is lowered to 0.2 - 0.3 kg/$cm^2$, thereby lowering the kinetic energy exerted on the sand to be blasted against the wafer. As a result of such low sand blasting pressure, the OSF density is reduced to a level of 300,000 - 700,000 pieces/$cm^2$, which reduction of OSF density brings about a corresponding reduction of EG effect of the semiconductor substrate.

Examples 3 and 4 and Comparative Example 2

(a) <u>Processes Effected on Wafers</u>

15 samples of wafers prepared in the same manner as the wafers in the preceding example 1 were used. 5 out of 15 wafers were used for the conventional method (Comparative Example 2), while the rest (10 wafers) were used for the inventive invention (Examples 3 and 4) in which a protective film of silicon nitride is formed on each wafer by CVD. 5 out of the last-mentioned 10 wafers were sandblasted and thereafter the nitride film was etched off in a dilute hydrofluoric acid solution (Example 4).

The CVD for forming the nitride film on the back side of the wafer was achieved at atmospheric pressure and at a deposition temperature of 800°C using $SiH_4$ and $NH_3$ as source gases until an 80 - 120Å thickness protective film was formed.

(a-i) <u>Processes Effected on Comparative Example 2 (Conventional Method)</u>:

wafer $\rightarrow$ annealing (650°C, 30 min., nitrogen gas atmosphere) $\rightarrow$ dry sandblasting (sand blasting pressure: 0.8 kg/$cm^2$) $\rightarrow$ inspection

(a-ii) <u>Processes Effected on Examples 3 and 4 (Inventive Method)</u>:

wafer $\rightarrow$ annealing (650°C, 30 min., nitrogen gas atmosphere) $\rightarrow$ CVD film formation $\rightarrow$ dry sandblasting (sand blasting pressure: 0.8 kg/$cm^2$) $\rightarrow$ inspection

(b) Test Results

The results obtained are as shown in Table 2.

The test conditions used in these Examples 3 and 4 were previously set such that the OSF density produced by sandblasting on the back side of the wafer became a value around 1,000,000 pieces/$cm^2$. Thus, the test results obtained in respect of Examples 3 and 4 have the same tendency as those of Examples 1 and 2. In other words, in order to obtain the same effect, the thickness of the silicon nitride film formed by the CVD in Examples 3 and 4 must be greater than that of the silicon oxide film formed by thermal oxidation in the Examples 1 and 2.

This is probably because the silicon oxide film and the silicon nitride film are different (a) in peculiar physical properties, (b) in film thickness structure resulting from a difference in method of forming the respective films, and (c) in condition of the interface between the film and the wafer. But, it is unknown as to which factor constitutes a major reason.

When the protective film composed of a silicon nitride film is desired, a thermal nitriding method may be used. The thermal nitriding method is advantageous in that a nitrogen atmosphere used in the conventional annealing process can be used without change. However, thermal nitriding of silicon requires a high reaction temperature not less than 1000°C. It can, therefore, be understood that the CVD is advantageous over the thermal nitriding because the nitride film can be formed at a relatively low temperature.

Experment 1

Those samples used in the OSF density measurement in Examples 1 and 2 and Comparative Example 1 were subjected to a further heat treatment contemplated by an oxygen precipitation test, and after that the OSF density on the wafer back side was measured again. The heat treatment was effected at 800°C for 4 hours in an $N_2$ atmosphere and at 1100°C for 12 hours in an $O_2$ atmosphere.

The results obtained are as shown in Table 3.

Since the stability of the EG effect is gradually improved as the reduction rate of OSF density decreases, Example 1 (a wafer with a silicon oxide film left unremoved) exhibits a remarkable advantage over Comparative Example 1.

As described above, according to the present invention, a distorted layer is introduced in the back side of a wafer by means of a dry sandblasting or a wet sandblasting without generating mechanical fractures on the back side of the wafer. The distorted layer will provide a long lasting EG effect even when subjected to a heat treatment at a high temperature when the wafer is processed into a device.

Table 1

|  | Comparative Example 1 | Example 1 | Example 2 |
|---|---|---|---|
| OSF Density ($10^3$ pieces/$cm^2$) | 1408 | 1449 | 1226 |
|  | 1221 | 1353 | 1369 |
|  | 1265 | 1265 | 1389 |
|  | 1245 | 1188 | 1416 |
|  | 1210 | 1293 | 1389 |
| Average | 1290 | 1310 | 1358 |
| Number of Mechanical Fractures (piece/wafer) | 11 | 2 | 1 |
|  | 12 | 0 | 0 |
|  | 16 | 0 | 0 |
|  | 13 | 0 | 2 |
|  | 15 | 1 | 2 |
| Average | 13.4 | 0.6 | 1.0 |

Table 1   (continued)

| | Comparative Example 1 | Example 1 | Example 2 |
|---|---|---|---|
| Depth of Mechanical Fractures ($\mu$m) | 6.22 | 3.94 | 3.82 |
| | 6.56 | 2.62 | 4.25 |
| | 6.12 | 3.28 | 2.62 |
| | 5.91 | 2.64 | 2.97 |
| | 5.69 | 3.15 | 3.28 |
| Average | 6.10 | 3.13 | 3.39 |

Table 2

| | Comparative Example 2 | Example 3 | Example 4 |
|---|---|---|---|
| OSF Density ($10^3$ pieces/cm$^2$) | 1397 | 1226 | 1499 |
| | 1316 | 1369 | 1353 |
| | 1383 | 1388 | 1265 |
| | 1415 | 1416 | 1188 |
| | 1320 | 1389 | 1293 |
| Average | 1366 | 1358 | 1320 |
| Number of Mechanical Fractures (piece/wafer) | 15 | 0 | 2 |
| | 22 | 1 | 0 |
| | 13 | 1 | 0 |
| | 18 | 2 | 1 |
| | 19 | 1 | 1 |
| Average | 17.4 | 1.0 | 0.8 |
| Depth of Mechanical Fractures ($\mu$m) | 5.86 | 2.71 | 5.10 |
| | 5.92 | 3.39 | 3.36 |
| | 6.57 | 4.15 | 3.51 |
| | 5.91 | 3.66 | 3.86 |
| | 6.69 | 2.83 | 2.39 |
| Average | 6.19 | 3.35 | 3.64 |

Table 3

| | Comparative Example 1 | Example 1 | Example 2 |
|---|---|---|---|
| OSF Density before Heat Treatment ($10^3$ pieces/cm$^2$) | 1408 | 1449 | 1226 |
| | 1221 | 1353 | 1369 |
| | 1265 | 1265 | 1389 |
| | 1245 | 1188 | 1416 |
| | 1210 | 1293 | 1389 |
| Average | 1290 | 1310 | 1358 |

Table 3   (continued)

| | Comparative Example 1 | Example 1 | Example 2 |
|---|---|---|---|
| OSF Density after Heat Treatment ($10^3$ pieces/cm$^2$) | 1092 | 1226 | 982 |
| | 931 | 1083 | 1063 |
| | 876 | 1149 | 1138 |
| | 1038 | 1205 | 1085 |
| | 964 | 1188 | 1096 |
| Average | 980 | 1170 | 1073 |
| OSF Reduction Rate (% on average) | 24.0 | 10.7 | 21.0 |

## Claims

1. A method of making a semiconductor substrate, comprising the steps of:

   forming an inorganic protective film on a back side of a silicon single crystal wafer; and
   subsequently, introducing a distorted layer in said back side of said wafer by a sandblasting method.

2. A method according to claim 1, wherein said protective film is a silicon oxide layer.

3. A method according to claim 2, wherein said protective film is formed by annealing said silicon single crystal wafer in an oxidizing atmosphere.

4. A method according to claim 1, wherein said protective film is a silicon nitride layer.

5. A method according to claim 1, wherein said protective film is an inorganic film formed by chemical vapour deposition.

6. A method according to claim 1, wherein said protective film is an inorganic film formed by a wet process.

7. A method according to claim 6, wherein said wet process is a wet oxidation process, an anodic oxidation process, or a liquid-phase film-forming process.

8. A method according to claim 1, further comprising removing said protective film after said sandblasting is achieved.

## Patentansprüche

1. Ein Verfahren zur Herstellung eines halbleitenden Substrates, das folgende Schritte umfaßt:

   Ausbilden eines anorganischen Schutzfilmes auf einer Rückseite eines Silizium-Einkristallwafers und

   nachfolgendes Einbringen einer gestörten Schicht in die Rückseite des Wafers mittels Sandstrahlen.

2. Das Verfahren nach Anspruch 1, **dadurch gekennzeichnet,** daß der Schutzfilm eine Siliziumoxidschicht ist.

3. Das Verfahren nach Anspruch 2, **dadurch gekennzeichnet,** daß der Schutzfilm mittels Glühen des Silizium-Einkristallwafers in einer oxidierenden Atmosphäre ausgebildet wird.

4. Das Verfahren nach Anspruch 1, **dadurch gekennzeichnet,** daß der Schutzfilm eine Siliziumnitridschicht ist.

5. Das Verfahren nach Anspruch 1, **dadurch gekennzeichnet,** daß der Schutzfilm ein anorganischer Film ist, der mittels Gasphasenabscheidung nach chemischem Verfahren (CVD) ausgebildet wird.

6. Das Verfahren nach Anspruch 1, **dadurch gekennzeichnet,** daß der Schutzfilm ein anorganischer Film ist, der mittels eines Naßverfahrens ausgebildet wird.

7. Das Verfahren nach Anspruch 6, **dadurch gekennzeichnet**, daß das Naßverfahren ein Naßoxidationsverfahren, ein anodisches Oxidationsverfahren oder ein Filmbildungsverfahren aus einer flüssigen Phase ist.

8. Das Verfahren nach Anspruch 1, **dadurch gekennzeichnet,** daß außerdem ein Schritt durchgeführt wird, bei dem ein Entfernen des Schutzfilmes nach dem Sandstrahlen bewirkt wird.

## Revendications

1. Procédé pour produire un substrat semi-conducteur, comprenant les étapes consistant à :

    former un film inorganique protecteur sur un côté arrière d'une tranche en monocristal de silicium ; et ensuite, faire pénétrer une couche déformée dans ledit côté arrière de ladite tranche par un procédé de sablage.

2. Procédé selon la revendication 1, dans lequel ledit film protecteur est une couche d'oxyde de silicium.

3. Procédé selon la revendication 2, dans lequel on forme ledit film protecteur en faisant recuire ladite tranche en monocristal de silicium sous une atmosphère oxydante.

4. Procédé selon la revendication 1, dans lequel ledit film protecteur est une couche en nitrure de silicium.

5. Procédé selon la revendication 1, dans lequel ledit film protecteur est un film inorganique formé par dépôt chimique en phase vapeur.

6. Procédé selon la revendication 1, dans lequel ledit film protecteur est un film inorganique formé par un traitement par voie humide.

7. Procédé selon la revendication 6, dans lequel ledit traitement par voie humide est un traitement d'oxydation par voie humide, un traitement d'oxydation anodique, ou un traitement pour former un film en phase liquide.

8. Procédé selon la revendication 1, comprenant en outre l'élimination dudit film protecteur après que l'on ait réalisé ledit sablage.